# EUROPEAN PATENT APPLICATION

(11) **EP 4 362 086 A1**
(43) Date of publication of application: **01.05.2024**
(21) Application number: 21953760.2
(22) Date of filing: 19.08.2021
(51) Int. Cl.: H01L 23/498, H01L 23/538

(54) **CHIP PACKAGE STRUCTURE AND ELECTRONIC APPARATUS**

(71) Applicant: Huawei Technologies Co., Ltd., Longgang Shenzhen, Guangdong 518129 (CN)
(72) Inventor: ZHAO, Nan, Shenzhen, Guangdong 518129 (CN); XIE, Wenxu, Shenzhen, Guangdong 518129 (CN); LI, Pinhui, Shenzhen, Guangdong 518129 (CN); CHIANG, Shanghsuan, Shenzhen, Guangdong 518129 (CN)
(74) Representative: MERH-IP Matias Erny Reichl Hoffmann Patentanwälte PartG mbB
(86) International application number: PCT/CN2021/113573
(87) International publication number: WO 2023/019516

(57) **Abstract**

Embodiments of this application provide a chip package structure and an electronic device, and relate to the field of semiconductor technologies, to resolve a problem of how to reduce costs and complexity of an SBAFOP structure. In the chip package structure, a first chip and a second chip are disposed side by side on a first surface of a redistribution layer. A first connection chip is disposed on a second surface of the redistribution layer. A plurality of first contacts and a plurality of second contacts are disposed at a bottom of the first chip and a bottom of the second chip. The first contacts are distributed in areas that are at the bottom of the first chip and the bottom of the second chip and that are covered by projection of the first connection chip. The second contacts are distributed in areas that are at the bottom of the first chip and the bottom of the second chip and that are not covered by the projection of the first connection chip. A plurality of conductive columns are disposed around a periphery of the first connection chip. A first line path in the redistribution layer is used to electrically connect a part of the plurality of conductive columns to the first contact. A second line path in the redistribution layer is used to electrically connect a part of the plurality of conductive columns to the second contact.

## Description

### TECHNICAL FIELD

This application relates to the field of semiconductor technologies, and in particular, to a chip package structure and an electronic device.

### BACKGROUND

As electronic technologies develop, functions of electronic devices are continuously enriched and comprehensive, so that a requirement for evolution and iteration of a high-order chip is constantly increased, chip integration is continuously improved, and multi-chip packaging with high-density integration becomes a trend.

A silicon bridge across fan out package (silicon bridge across fan out package, SBAFOP) technology is a package technology that implements low-cost and multi-chip integration, where a plurality of connected chips are interconnected through a connection chip. Compared with interconnection performed through a redistribution layer, interconnection performed through the connection chip may shorten an interconnection path between the connected chips. Therefore, compared with a structure using a 2.5D fan out package (fan out package, FOP) technology, in a structure using the SBAFOP package technology, performance is greatly improved.

However, in an SBAFOP structure in a conventional technology, a power supply signal on a package substrate is transmitted to a connected chip through a conductive column or a through silicon via (through silicon via, TSV), and a complex process needs to be used to form the TSV Consequently, costs and complexity of a product are increased.

### SUMMARY

Embodiments of this application provide a chip package structure and an electronic device, to resolve a problem of how to reduce costs and complexity of an SBAFOP structure without affecting internal power supply of SBAFOP.

To achieve the foregoing objective, this application uses the following technical solutions.

A first aspect of embodiments of this application provides a chip package structure, including a first chip, a second chip, a first connection chip, a redistribution layer, a plurality of conductive columns, and a package substrate. The redistribution layer includes a first surface and a second surface that are opposite to each other. The first chip and the second chip are disposed side by side on the first surface of the redistribution layer, and the first chip and the second chip are spaced from each other. The first connection chip is disposed on the second surface of the redistribution layer. A plurality of first contacts and a plurality of second contacts are disposed at a bottom of the first chip and a bottom of the second chip. The first contacts are distributed in areas that are at the bottom of the first chip and the bottom of the second chip and that are covered by projection of the first connection chip. The second contacts are distributed in areas that are at the bottom of the first chip and the bottom of the second chip and that are not covered by the projection of the first connection chip. The redistribution layer is supported above the package substrate by the plurality of conductive columns, and the plurality of conductive columns are disposed around a periphery of the first connection chip. A first line path and a second line path are disposed in the redistribution layer. The first line path is used to electrically connect a part of the plurality of conductive columns to the first contact, and the second line path is used to electrically connect a part of the plurality of conductive columns to the second contact.

According to the chip package structure provided in this embodiment of this application, the package substrate is welded to the conductive columns through C4 bumps or solder balls, and signals on the package substrate are transmitted to the conductive columns. The conductive columns are arranged around the periphery of the first connection chip, and are electrically connected to the redistribution layer. The signals on the conductive columns are transmitted to the first chip and the second chip through line paths in the redistribution layer, to supply power to the first chip and the second chip. Compared with a power supply manner in which a TSV and a plurality of redistribution layers are formed in the first connection chip, a power supply manner used in this embodiment of this application can reduce costs on a basis of ensuring a power supply requirement of an internal circuit of the chip package structure. Compared with a manner in which the first chip and the second chip are interconnected and powered by using the redistribution layer instead of a connection chip, the power supply manner used in this embodiment of this application can reduce a quantity of metal layers in the redistribution layer, and reduce a thickness of the redistribution layer. In addition, because the TSV does not need to be formed in the first connection chip to transmit a power supply signal on the package substrate, an area of the first connection chip may be reduced. This helps implement short-distance and high-density interconnection between the first chip and the second chip. Therefore, a requirement of a chip that features a high bandwidth, a high rate, high performance, and low costs is met.

In some embodiments, a plurality of first auxiliary contacts are further disposed on a side that is of the first connection chip and that faces the redistribution layer, and the first auxiliary contacts and the first contacts are disposed correspondingly. The redistribution layer further includes a third line path, and the third line path is used to electrically connect a part of the plurality of conductive columns to the first auxiliary contact. Signals on the conductive columns are transmitted to the first connection chip through the line path in the redistribution layer, to supply power to the first connection chip. Compared with a power supply manner in which a TSV is formed in the first connection chip, a power supply manner used in this embodiment of this application can reduce costs and an area of the first connection chip on a basis of ensuring a power supply requirement of an internal circuit of the chip package structure.

In some embodiments, at least a part of the first auxiliary contacts is electrically connected in the first connection chip. The redistribution layer further includes a fourth line path, and the fourth line path is used to electrically connect the first contact at the bottom of the second chip to the first auxiliary contact at a corresponding position of the first connection chip. The fourth line path is disposed in the redistribution layer, so that a power supply signal on a conductive column that is close to the first chip can be transmitted to the second chip through the first connection chip. In this way, when a power supply requirement of the second chip is large, and space for disposing a conductive column on a side on which the second chip is located is insufficient, the conductive column on a side on which the first chip is located is used to supply power to the second chip, so that a power supply requirement of the second chip can be met.

A new power supply path may be included in the chip package structure, so that a power supply network of the chip package structure can be enriched, and an application scope of the chip package structure can be improved.

In some embodiments, a plurality of second auxiliary contacts are further disposed on the side that is of the first connection chip and that faces the redistribution layer, and the second auxiliary contacts are distributed in an area that is of the first connection chip and that is not covered by projection of the first chip or the second chip. The second auxiliary contacts are disposed between a first overlapping area where the area covered by projection of the first connection chip and the first chip overlap and a second overlapping area where the area covered by projection of the first connection chip and the second chip overlap, and the second auxiliary contacts are connected to the redistribution layer. This is equivalent to adding support by using the second auxiliary contacts, to increase support strength at a spacing between the first chip and the second chip, and avoid breaking of the chip package structure at the spacing between the first chip and the second chip.

In some embodiments, at least a part of the second auxiliary contacts and a part of the first auxiliary contacts are electrically connected in the first connection chip. The redistribution layer further includes a fifth line path, and the fifth line path is used to electrically connect a part of the plurality of conductive columns to the second auxiliary contact. A new power supply path may be included in the chip package structure, so that a power supply network of the chip package structure can be enriched, and an application scope of the chip package structure can be improved.

In some embodiments, the redistribution layer further includes a sixth line path, and the sixth line path is used to electrically connect the first contact at the bottom of the first chip to the first auxiliary contact at a corresponding position of the first connection chip. A new power supply path may be included in the chip package structure, so that a power supply network of the chip package structure can be enriched, and an application scope of the chip package structure can be improved.

In some embodiments, the redistribution layer further includes a seventh line path, and the seventh line path is used to electrically connect at least a part of the second auxiliary contacts. A new power supply path may be included in the chip package structure, so that a power supply network of the chip package structure can be enriched, and an application scope of the chip package structure can be improved.

In some embodiments, the first chip and the second chip further include a plurality of third contacts, and the third contacts are distributed in the areas that are at the bottom of the first chip and the bottom of the second chip and that are covered by the projection of the first connection chip. The first connection chip further includes a plurality of third auxiliary contacts, and the third auxiliary contacts and the third contacts are distributed correspondingly. The redistribution layer further includes an eighth line path, and the eighth line path is used to electrically connect the third contact to the third auxiliary contact. Therefore, a manner in which the first chip and the second chip are interconnected through the first connection chip is implemented.

In some embodiments, the first line path is used to transmit an intellectual property power supply signal and a ground signal. The second line path is used to transmit the intellectual property power supply signal, a core power supply signal, and the ground signal.

In some embodiments, the chip package structure further includes a second connection chip. The second connection chip and the first connection chip are disposed side by side on the second surface of the redistribution layer. Projection of the second connection chip covers a part of areas of the first chip and the second chip. When an interconnection area between the first chip and the second chip is large, or a plurality of groups of functional areas that need to be interconnected are far away from each other, a plurality of connection chips are disposed, so that a line path can be shortened, performance after interconnection is improved, and different structure requirements are met.

In some embodiments, the chip package structure further includes a third chip. The third chip is disposed on the first surface of the redistribution layer, and is spaced from the first chip and the second chip. A part of an area of the third chip is covered by the projection of the first connection chip. The chip package structure has a flexible design and strong adaptability.

A second aspect of embodiments of this application provides an electronic device, including the chip package structure according to the first aspect and a printed circuit board. The chip package structure is disposed on the printed circuit board.

The electronic device provided in this embodiment of this application includes the chip package structure according to the first aspect, and beneficial effects of the electronic device are the same as beneficial effects of the chip package structure. Details are not described herein again.

### BRIEF DESCRIPTION OF DRAWINGS

FIG. 1 is a schematic diagram of a structure of an electronic device according to an embodiment of this application;
FIG. 2 is a schematic diagram of a structure of a chip package structure according to an embodiment of this application;
FIG. 3A is a schematic diagram of a structure of another chip package structure according to an embodiment of this application;
FIG. 3B is a schematic diagram of a structure of still another chip package structure according to an embodiment of this application;
FIG. 4A is a schematic diagram of a part of power supply paths of a chip package structure according to an embodiment of this application;
FIG. 4B is a top view of a chip package structure according to an embodiment of this application;
FIG. 4C is a schematic diagram of a part of power supply paths of another chip package structure according to an embodiment of this application;
FIG. 5A is a sectional view in a direction A1-A2 in FIG. 4B according to an embodiment of this application;
FIG. 5B is a sectional view in a direction B1-B2 in FIG. 4B according to an embodiment of this application;
FIG. 6A is a schematic diagram of a part of power supply paths of still another chip package structure according to an embodiment of this application;
FIG. 6B is a schematic diagram of a part of power supply paths of still another chip package structure according to an embodiment of this application;
FIG. 6C is a schematic diagram of a part of power supply paths of still another chip package structure according to an embodiment of this application;
FIG. 7 is a schematic diagram of a part of power supply paths of still another chip package structure according to an embodiment of this application;
FIG. 8 is a schematic diagram of a part of power supply paths of still another chip package structure according to an embodiment of this application;
FIG. 9A is a top view of another chip package structure according to an embodiment of this application;
FIG. 9B is a top view of still another chip package structure according to an embodiment of this application;
FIG. 9C is a sectional view in a direction C1-C2 in FIG. 9A according to an embodiment of this application;
FIG. 9D is a sectional view in a direction D1-D2 in FIG. 9A according to an embodiment of this application;
FIG. 9E is a sectional view in a direction E1-E2 in FIG. 9A according to an embodiment of this application;
FIG. 10A is a top view of still another chip package structure according to an embodiment of this application;
FIG. 10B is a sectional view in a direction F1-F2 in FIG. 10A according to an embodiment of this application;
FIG. 10C is a sectional view in a direction G1-G2 in FIG. 10A according to an embodiment of this application;
FIG. 11A is a top view of still another chip package structure according to an embodiment of this application;
FIG. 11B is a sectional view in a direction H1-H2 in FIG. 11A according to an embodiment of this application;
FIG. 11C is a sectional view in a direction I1-I2 in FIG. 11A according to an embodiment of this application;
FIG. 12A is a schematic diagram of a part of power supply paths of still another chip package structure according to an embodiment of this application;
FIG. 12B is a schematic diagram of a part of power supply paths of still another chip package structure according to an embodiment of this application;
FIG. 13A is a top view of still another chip package structure according to an embodiment of this application;
FIG. 13B is a top view of still another chip package structure according to an embodiment of this application;
FIG. 14A is a top view of still another chip package structure according to an embodiment of this application; and
FIG. 14B is a top view of still another chip package structure according to an embodiment of this application.

### DESCRIPTION OF EMBODIMENTS

The following describes technical solutions in embodiments of this application with reference to the accompanying drawings in embodiments of this application. It is clear that the described embodiments are merely a part rather than all of embodiments of this application.

The terms such as "first" and "second" in embodiments of this application are merely intended for ease of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In embodiments of this application, "upper", "lower", "left", and "right" are not limited to definitions relative to directions in which components are schematically placed in the accompanying drawings. It should be understood that these directional terms may be relative concepts used for relative description and clarification, and may change correspondingly based on a change of a direction in which a component in the accompanying drawings is placed.

In embodiments of this application, unless otherwise specified in the context, throughout this specification and claims, the term "include" is interpreted as "open and inclusion", that is, "include, but are not limited to". In descriptions in this specification, terms such as "an embodiment", "some embodiments", "example embodiments", "for example", or "some examples" are intended to indicate that specific features, structures, materials, or characteristics related to embodiments or examples are included in at least one embodiment or example of this disclosure. The foregoing schematic representations of the terms do not necessarily refer to a same embodiment or example. In addition, the particular features, structures, materials, or characteristics may be included in any one or more embodiments or examples in any appropriate manner.

When some embodiments are described, expressions of "electrical connection" and "connection" and their extensions may be used. For example, when some embodiments are described, the term "connection" may be used to indicate that two or more components are in direct physical contact or electric contact with each other. For another example, when some embodiments are described, the term "electrical connection" may be used to indicate that two or more components are in direct physical contact or electric contact. However, the term "electrical connection" may alternatively mean that two or more components are not directly connected, but still cooperate or interact with each other. Embodiments disclosed herein are not necessarily limited to content of this specification.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In embodiments of this application, an example implementation is described with reference to a sectional view and/or a plane diagram and/or an equivalent circuit diagram that are/is used as an ideal example accompanying drawing. In the accompanying drawings, for clarity, thicknesses of a layer and an area are magnified. Therefore, a change in the shape of the accompanying drawings caused by, for example, a manufacturing technology and/or a tolerance, may be conceived. Therefore, an example implementation should not be construed as being limited to the shape of the area shown in this specification, but rather include a shape deviation caused by, for example, manufacturing. For example, an etching area shown as a rectangle usually has a bending characteristic. Therefore, the areas shown in the accompanying drawings are essentially used as an example, and shapes of the areas are not intended to show the actual shape of the areas of the device, and are not intended to limit the scope of the example implementation.

Embodiments of this application provide an electronic device. The electronic device may be a terminal device having a display interface, for example, a mobile phone, a television, a display, a tablet computer, or a vehicle-mounted computer; may be an intelligent display wearable device, for example, a smartwatch or a smart band; may be a communication device, for example, a server, a memory, or a base station; or may be a smart car, or the like. A specific form of the electronic device is not specifically limited in embodiments of this application. For ease of description, the following embodiments are described by using an example in which the electronic device is the mobile phone.

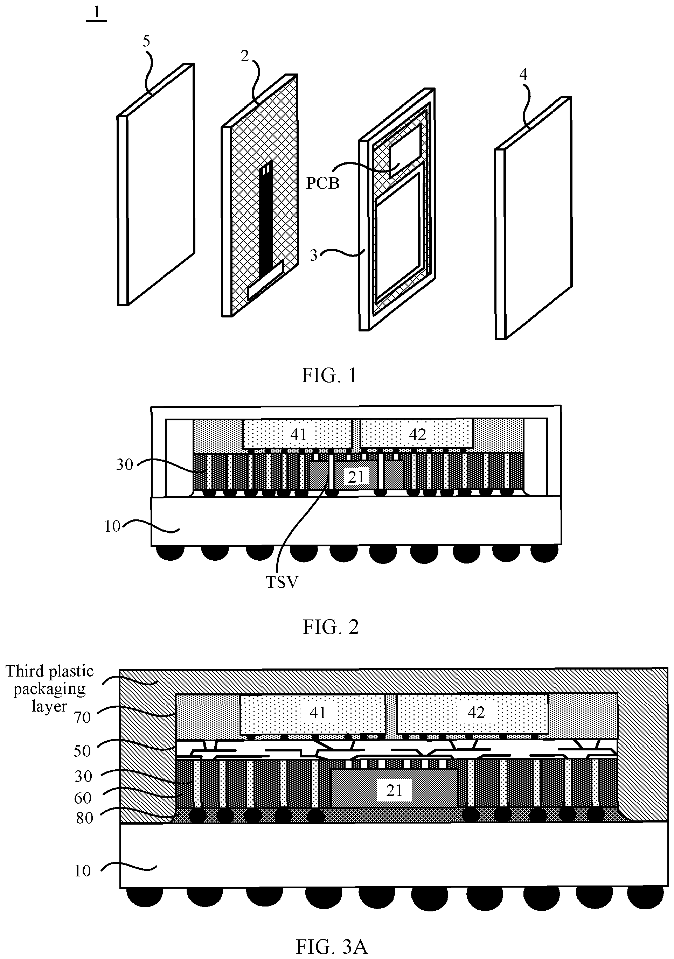

In this case, as shown in FIG. 1, an electronic device 1 mainly includes a display module 2, a middle frame 3, a housing (or referred to as a battery cover or a rear cover) 4, and a cover plate 5.

The display module 2 has a light emergence side on which a displayed image can be seen and a back surface disposed opposite to the light emergence side. The back surface of the display module 2 is close to the middle frame 3. The cover plate 5 is disposed on the light emergence side of the display module 2. The cover plate 5 is located on a side of the display module 2 away from the middle frame 3. For example, the cover plate 5 may be cover glass (cover glass, CG), and the cover glass may have specific toughness. The middle frame 3 is located between the display module 2 and the housing 4. A surface of the middle frame 3 away from the display module 2 is used to install internal components, for example, a battery, a printed circuit board (printed circuit board, PCB), a camera (camera), and an antenna. After the housing 4 covers the middle frame 3, the internal components are located between the housing 4 and the middle frame 3.

The electronic device 1 further includes electronic components that are disposed on the PCB, for example, a processor (central processing unit, CPU) chip, a radio frequency chip, a radio frequency power amplifier (power amplifier, PA) chip, a system on a chip (system on a chip, SoC), a power management integrated circuit (power management integrated circuit, PMIC), a memory chip (for example, a high bandwidth memory (high bandwidth memory, HBM)), an audio processor chip, a touchscreen control chip, a NAND flash (a flash memory), and an image sensor chip. The PCB is configured to: carry the foregoing electronic components, and complete signal exchange with the foregoing electronic components.

As electronic technologies develop, functions of the electronic device 1 are continuously enriched and comprehensive, so that a requirement for evolution and iteration of a high-order chip is constantly increased, chip integration in the electronic device 1 is continuously improved, and multi-chip packaging with high-density integration becomes a trend.

Based on this, to improve the chip integration in the electronic device 1, an embodiment of this application provides a chip package structure. As shown in FIG. 2, the chip package structure includes a package substrate 10. A first connection chip 21 is disposed on the package substrate 10, and the first connection chip 21 has a plurality of through silicon vias (through silicon vias, TSVs). Conductive columns 30 are disposed on the package substrate 10, and are located around a periphery of the first connection chip 21. A first chip 41 is disposed above the conductive column 30 the first connection chip 21, and is electrically connected to the conductive column 30 and the first connection chip 21. A second chip 42 is disposed above the conductive column 30 and the first connection chip 21, and is electrically connected to the conductive column 30 and the first connection chip 21.

As shown in FIG. 2, in areas that are of the first chip 41 and the second chip 42 and that are covered by projection of the first connection chip 21, the first chip 41 and the second chip 42 cannot directly transmit signals through the conductive columns 30, and power supply signals on the package substrate 10 are transmitted to the first chip 41 and the second chip 42 through the through silicon vias TSVs in the first connection chip 21. Consequently, to implement transmission of the power supply signals in the areas that are of the first chip 41 and the second chip 42 and that are covered by the projection of the first connection chip 21, structural complexity and costs of the first connection chip 21 are increased.

Based on this, an embodiment of this application further provides a chip package structure. As shown in FIG. 3A, the chip package structure includes a package substrate 10, a first connection chip 21, a plurality of conductive columns 30, a first chip 41, a second chip 42, and a redistribution layer 50.

The redistribution layer (redistribution layer, RDL) 50 includes a first surface and a second surface that are opposite to each other.

The redistribution layer 50 includes a metal layer and an insulation layer that are alternately arranged. A material of the metal layer may include, for example, one or more conductive materials of copper, aluminum, nickel, gold, silver, and titanium. A material of the insulation layer may include, for example, one or more of silicon oxide, silicon nitride, silicon oxynitride, silicone, and polyimide.

The first chip 41 and the second chip 42 are disposed side by side on the first surface of the redistribution layer 50, and are bonded to the redistribution layer 50. The first chip 41 and the second chip 42 are spaced from each other.

Specific structures of the first chip 41 and the second chip 42 are not limited in this embodiment of this application, and the chip may be any chip required by an electronic device. For example, each chip includes a chip substrate and a functional layer disposed on the chip substrate. In a working process, the functional layer may enable the chip to implement a function of the chip, for example, a logical computing function or a storage function. The functional layer mainly includes a functional component, a circuit structure, an interconnection metal wire, a dielectric layer, and the like.

In addition, the first chip 41 and the second chip 42 in the chip package structure in this embodiment of this application may be dies (or referred to as bare dies, or particles) cut from a wafer, or may be packaged chips obtained by packaging the dies. Certainly, a case in which both the first chip 41 and the second chip 42 need to be dies or packaged chips is not limited. Alternatively, the first chip 41 may be the die (for example, the foregoing SoC), and the second chip 42 may be the packaged chip (for example, the foregoing HBM).

In addition, when the first chip 41 and the second chip 42 in the chip package structure are electrically connected to the redistribution layer 50, one chip may be electrically connected to the redistribution layer 16 at a time, or a plurality of chips may be electrically connected to the redistribution layer 16 at a time.

In addition, thicknesses of the first chip 41 and the second chip 42 in a direction perpendicular to the package substrate 10 may be the same. The thicknesses of the first chip 41 and the second chip 42 in the direction perpendicular to the package substrate 10 may alternatively be different. This is not limited in this embodiment of this application.

To simplify the structure and facilitate an electrical connection, in some embodiments, both an active surface of each first chip 41 and an active surface of each second chip 42 face the base plate 10. Pads (pads) may be exposed on the active surfaces of the first chip 41 and the second chip 42, or a bump (bump) structure may be formed on the pad. The bump structure may be, for example, a ball bump (ball bump) or a copper pillar bump (Cu bump).

The first connection chip 21 is disposed on the second surface of the redistribution layer 50, and is electrically connected to the redistribution layer 50. The first connection chip 21 is located between the redistribution layer 50 and the package substrate 10.

Projection of the first connection chip 21 covers a part of areas of the first chip 41 and the second chip 42.

In other words, a part of the area of the first chip 41 is located right above the first connection chip 21, and a part of the area of the second chip 42 is located right above the first connection chip 21. Alternatively, it is understood as that a part of the area of the first chip 41 is lapped over the first connection chip 21, and a part of the area of the second chip 42 is lapped over the first connection chip 21. The first chip 41 and the second chip 42 are interconnected through the first connection chip 21.

For the first connection chip 21, for example, a required line may be directly made on the wafer as required, and then the first connection chip 21 is obtained through cutting, and used in the chip package structure. For example, the first connection chip 21 may be understood as a silicon bridge die (silicon bridge die, SBD). Certainly, a material of a chip substrate of the first connection chip 21 may include, for example, one or more of silicon (Si), germanium (Ge), gallium nitride (GaN), gallium arsenide (GaAs), or another semiconductor material. In addition, the material of the chip substrate may be, for example, glass (glass) or an organic material. The silicon bridge die is only used as an example.

In some embodiments, an active surface of the first connection chip 21 faces the redistribution layer 50, and is electrically connected to the redistribution layer 50. A back surface of the first connection chip 21 is disposed on the package substrate 10, and is fixedly connected to the package substrate 10.

In some embodiments, no TSV is provided in the first connection chip 21.

In this case, in some embodiments, the back surface of the first connection chip 21 is attached to the package substrate 10.

For example, the back surface of the first connection chip 21 is attached to the package substrate 10 by using a die attach film (die attach film, DAF). Alternatively, for example, the back surface of the first connection chip 21 is attached to the package substrate 10 by using a doublesided tape.

In some other embodiments, a TSV is provided in the first connection chip 21.

In this case, in some embodiments, the TSV in the first connection chip 21 is electrically connected to the package substrate 10 on the back surface of the first connection chip 21.

For example, the TSV in the first connection chip 21 is coupled to the base plate 10 in a fusion bonding (fusion bonding) manner or an adhesive bonding (adhesive bonding) manner.

In this embodiment of this application, the TSV in the first connection chip 21 is not used to transmit a power supply signal on the package substrate 10 to the first chip 41 or the second chip 42, but is used for another function. The another function may be, for example, transmitting the power supply signal on the package substrate 10 to the first connection chip 21, to improve utilization of a pin on the package substrate 10 below the first connection chip 21.

The redistribution layer 50 is supported above the package substrate 10 by the plurality of conductive columns 30. The plurality of conductive columns 30 are disposed around a periphery of the first connection chip 21, and the plurality of conductive columns 30 are electrically connected to both the package substrate 10 and the redistribution layer 50, to transmit the signals on the package substrate 10 to the redistribution layer 50.

A material of the conductive column 30 may include, for example, one or more of titanium (Ti), copper (Cu), nickel (Ni), cobalt (Co), tungsten (W), or a related alloy.

For a manner of electrically connecting the conductive columns 30 to the package substrate 10, in some embodiments, as shown in FIG. 3A, the conductive columns 30 are welded to the package substrate 10 through controlled collapse chip connection bumps (controlled collapse chip connection bumps, C4 bumps) or solder balls.

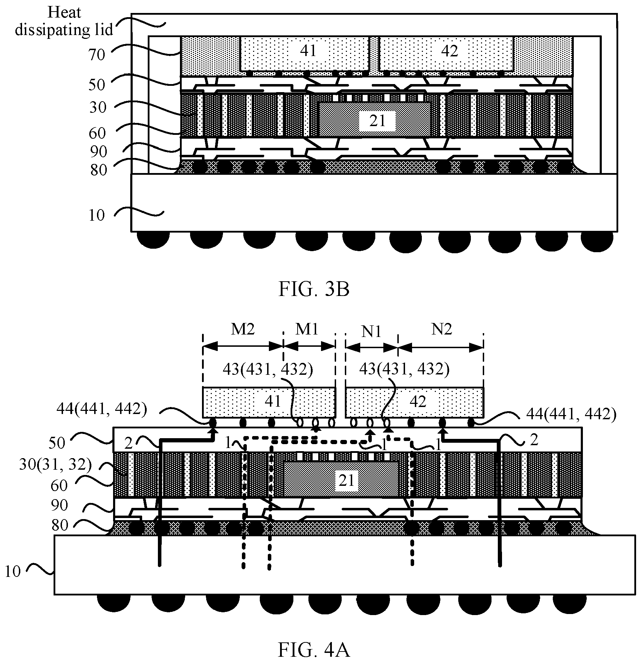

In some other embodiments, as shown in FIG. 3B, a second redistribution layer 90 is further disposed between the conductive columns 30 and the package substrate 10. The second redistribution layer 90 is welded to the package substrate 10 through C4 bumps or solder balls.

The second redistribution layer 90 may include only a single metal layer, or may include a plurality of metal layers. This is not limited in this embodiment of this application.

Certainly, the conductive column 30 may alternatively be electrically connected to the package substrate 10 in another manner. This is not limited in this embodiment of this application.

In some embodiments, the chip package structure further includes a first plastic packaging layer 60. The first plastic packaging layer 60 wraps side surfaces of the first connection chip 21 and the conductive columns 30, and exposes the active surface of the first connection chip 21 and top surfaces of the conductive columns 30, to protect the first connection chip 21 and the conductive columns 30.

A material of the first plastic packaging layer 60 may be, for example, a molding (molding) compound, an epoxy resin adhesive (epoxy resin adhesive, ERA), or an insulating material.

In some embodiments, the chip package structure further includes a second plastic packaging layer 70, and the second plastic packaging layer wraps at least side surfaces of the first chip 41 and the second chip 42, to protect the first chip 41 and the second chip 42.

In some embodiments, as shown in FIG. 3A and FIG. 3B, the chip package structure further includes an underfill layer 80 filled around peripheries of the C4 bumps or the solder balls.

As shown in FIG. 3A, the underfill layer 80 is located between the first plastic packaging layer 60 and the package substrate 10. Alternatively, as shown in FIG. 3B, the underfill layer 80 is located between the second redistribution layer 90 and the package substrate 10.

For example, the underfill layer 80 may be formed by using any one of a capillary underfill (capillary underfill, CUF) process, a molded underfill (molded underfill, MUF) process, a non-conductive film (non-conductive film, NCF) process, or a non-conductive paste (non-conductive paste, NCP) process.

In some embodiments, the chip package structure further includes at least one of a ring (ring), a heat dissipating lid, or a third plastic packaging layer.

The ring is disposed on a surface of the package substrate 10, and is located around a periphery of the first plastic packaging layer 60.

The heat dissipating lid and the package substrate 10 are buckled. The first connection chip 21, the conductive columns 30, the first chip 41, the second chip 42, the first plastic packaging layer 60, the second plastic packaging layer 70, and the underfill layer 80 are all located in an accommodating chamber formed by buckling the heat dissipating lid and the package substrate 10.

The third plastic packaging layer wraps at least side surfaces of the first plastic packaging layer 60, the second plastic packaging layer 70, and the underfill layer 80. The third plastic packaging layer may further cover top surfaces of the second plastic packaging layer 70, the first chip 41, and the second chip 42.

FIG. 3A is illustrated by using an example in which the chip package structure includes the third plastic packaging layer. FIG. 3B is illustrated by using an example in which the chip package structure includes the heat dissipating lid.

It should be noted that, the foregoing merely shows that one group of the first chip 41 and the second chip 42 are interconnected through the first connection chip 21 in the chip package structure. The chip package structure may have a plurality of unit groups that include the first chip 41, the second chip 42, and the first connection chip 21.

According to the chip package structure provided in this embodiment of this application, the first chip 41 and the second chip 42 are interconnected through the first connection chip 21. Compared with a manner in which connection cabling is performed on the package substrate 10, in the foregoing manner, the first connection chip 21 has higher integration, so that an obtained chip package structure has higher integration, and is applicable to high performance computing (high performance computing, HPC) packaging with ultra-high integration.

The following uses examples to describe a method for implementing power supply in the foregoing chip package structure.

### Example 1

As shown in FIG. 4A, a plurality of first contacts 43 and a plurality of second contacts 44 are disposed at a bottom of the first chip 41 and a bottom of the second chip 42.

The first contacts 43 are distributed in areas that are at the bottom of the first chip 41 and the bottom of the second chip 42 and that are covered by projection of the first connection chip 21. To be specific, the first contacts 43 are distributed in areas that are of the first chip 41 and the second chip 42, that are located right above the first connection chip 21, and that overlap the area covered by projection of the first connection chip 21.

The second contacts 44 are distributed in areas that are at the bottom of the first chip 41 and the bottom of the second chip 42 and that are not covered by projection of the first connection chip 21. That is, the second contacts 44 are distributed in areas that are of the first chip 41 and the second chip 42 and that do not overlap the first connection chip 21.

The first contacts 43 and the second contacts 44 may be of conductive structures such as pads, solder balls, and conductive columns.

A first line path 1 is disposed in the redistribution layer 5050. The first line path 1 is used to electrically connect a part of the plurality of conductive columns 30 to the first contact 43. In this way, the power supply signals on the package substrate 10 are transmitted to the first line paths 1 through the conductive columns 30, then transmitted to the first contacts 43 at the bottom of the first chip 41 and the bottom of the second chip 42 through the first line paths 1, and then transmitted to the inner areas that are of the first chip 41 and the second chip 42 and that are covered by projection of the first connection chip 21.

A second line path 2 is further disposed in the redistribution layer 50. The second line path 2 is used to electrically connect a part of the plurality of conductive columns 30 to the second contact 44. In this way, the power supply signals on the package substrate 10 are transmitted to the second line paths 2 through the conductive columns 30, then transmitted to the second contacts 44 at the bottom of the first chip 41 and the bottom of the second chip 42 through the second line paths 2, and then transmitted to the inner areas that are of the first chip 41 and the second chip 42 and that are not covered by projection of the first connection chip 21.

A type of the signal transmitted on the first line path 1 is not limited. For example, a part of the first line paths 1 may be used to transmit an intellectual property (intellectual property, IP) power supply signal, and supply power to IP units in the first chip 41 and the second chip 42. A part of the first line path 1 may be used to transmit a ground (ground) signal, to implement current return of power supply and signals of the first chip 41 and the second chip 42.

Similarly, a type of the signal transmitted on the second line path 2 is not limited. For example, a part of the second line paths 2 may be used to transmit the IP power supply signal, and a part of the second line paths 2 may be used to transmit the ground signal. A part of the second line paths 2 may further be used to transmit a core (core) power supply signal, and supply power to core units of the first chip 41 and the second chip 42.

In addition, the first line path 1 and the second line path 2 may be implemented by adjusting a quantity of metal layers and a pattern of each metal layer in the redistribution layer 50. A specific path is not limited, provided that power supply effects of the first line path 1 and the second line path 2 can be implemented.

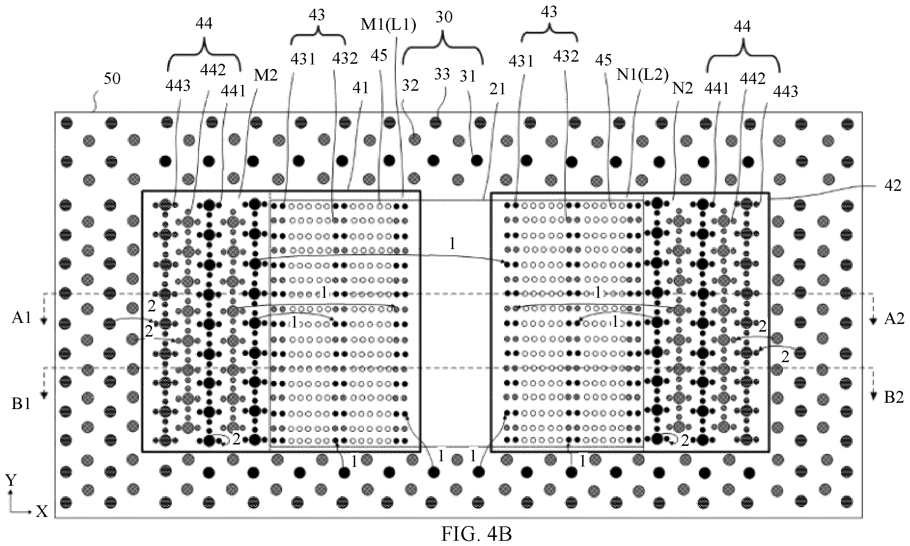

Based on this, as shown in FIG. 4B, the plurality of conductive columns 30 in the chip package structure may include a plurality of IP power supply conductive columns 31, a plurality of core power supply conductive columns 33, and a plurality of ground conductive columns 32.

The plurality of IP power supply conductive columns 31, the plurality of core power supply conductive columns 33, and the plurality of ground conductive columns 32 are distributed in areas defined by the redistribution layer 50. A part of the conductive columns 30 is located below the first chip 41 and the second chip 42, and a part of the conductive columns 30 is located around peripheries of the first chip 41 and the second chip 42.

The plurality of first contacts 43 in the chip package structure include a first IP power supply contact 431 and a first ground contact 432.

The first IP power supply contact 431 and the first ground contact 432 are distributed in the area (referred to as a first covered area in this embodiment of this application) M1 that is of the first chip 41 and that is covered by projection of the first connection chip 21. The first IP power supply contact 431 and the first ground contact 432 are also distributed in the area (referred to as a second covered area in this embodiment of this application) N1 that is of the second chip 42 and that is covered by projection of the first connection chip 21.

The plurality of second contacts 44 in the chip package structure include a second IP power supply contact 441, a second ground contact 442, and a core power supply contact 443.

The second IP power supply contact 441, the second ground contact 442, and the core power supply contact 443 are distributed in the area (referred to as a first uncovered area in this embodiment of this application) M2 that is of the first chip 41 and that is not covered by projection of the first connection chip 21. The second IP power supply contact 441, the second ground contact 442, and the core power supply contact 443 are also distributed in the area (referred to as a second uncovered area in this embodiment of this application) N2 that is of the second chip 42 and that is not covered by projection of the first connection chip 21.

Descriptions are provided by using an example in which the conductive column 30 shown in FIG. 4A is the IP power supply conductive column 31, the first contact 43 is the first IP power supply contact 431, and the second contact 44 is the second IP power supply contact 441.

With reference to FIG. 4A and FIG. 4B, a part of the plurality of IP power supply conductive columns 31 is electrically connected to the first line path 1. The IP power supply signal on the package substrate 10 is transmitted to the first line path 1 through the IP power supply conductive column 31. The first line path 1 is electrically connected to the first IP power supply contact 431. The first line path 1 on the left side transmits the IP power supply signal to the first IP power supply contact 431 of the first chip 41, and then transmits the IP power supply signal to the first covered area M1 of the first chip 41. The first line path 1 on the right side transmits the IP power supply signal to the first IP power supply contact 431 of the second chip 42, and then transmits the IP power supply signal to the second covered area N1 of the second chip 42.

A part of the plurality of IP power supply conductive columns 31 is electrically connected to the second line path 2. The IP power supply signal on the package substrate 10 is transmitted to the second line path 2 through the IP power supply conductive column 31. The second line path 2 is electrically connected to the second IP power supply contact 441. The second line path 2 on the left side transmits the IP power supply signal to the second IP power supply contact 441 of the first chip 41, and then transmits the IP power supply signal to the first uncovered area M2 of the first chip 41. The second line path 2 on the right side transmits the IP power supply signal to the second IP power supply contact 441 of the second chip 42, and then transmits the IP power supply signal to the second uncovered area N2 of the second chip 42.

Similarly, descriptions are provided by using an example in which the conductive column 30 shown in FIG. 4A is the ground conductive column 32, the first contact 43 is the first ground contact 432, and the second contact 44 is the second ground contact 442.

With reference to FIG. 4A and FIG. 4B, a part of the plurality of ground conductive columns 32 is electrically connected to the first line path 1. The part of ground conductive columns 32 is electrically connected to the first ground contact 432 through the first line path 1. In this way, the ground signal on the package substrate 10 is transmitted to the first line path 1 on the left side through the ground conductive column 32 on the left side. The first line path 1 on the left side transmits the ground signal to the first ground contact 432 of the first chip 41, and then transmits the ground signal to the first covered area M1 of the first chip 41. The ground signal on the package substrate 10 is transmitted to the first line path 1 on the right side through the ground conductive column 32 on the right side. The first line path 1 on the right side transmits the ground signal to the first ground contact 432 of the second chip 42, and then transmits the ground signal to the second covered area N1 of the second chip 42.

Apart of the plurality of ground conductive columns 32 is electrically connected to the second line path 2. The part of ground conductive columns 32 is electrically connected to the second ground contact 442 through the second line path 2. In this way, the ground signal on the package substrate 10 is transmitted to the second line path 2 on the left side through the ground conductive column 32 on the left side. The second line path 2 on the left side transmits the ground signal to the second ground contact 442 of the first chip 41, and then transmits the ground signal to the first uncovered area M2 of the first chip 41. The ground signal on the package substrate 10 is transmitted to the second line path 2 on the right side through the ground conductive column 32 on the right side. The second line path 2 on the right side transmits the ground signal to the second ground contact 442 of the second chip 42, and then transmits the ground signal to the second uncovered area N2 of the second chip 42.

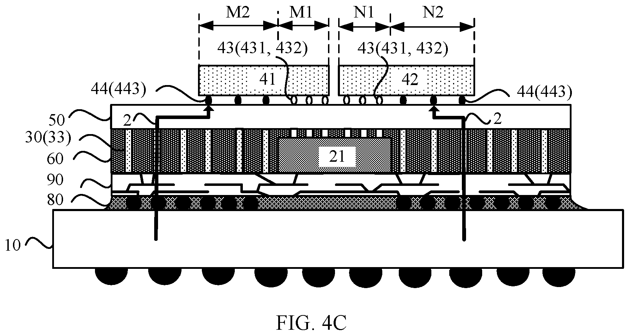

As shown in FIG. 4C, descriptions are provided by using an example in which the conductive column 30 is the core power supply conductive column 33, and the second contact 44 is the core power supply contact 443.

With reference to FIG. 4B and FIG. 4C, the plurality of core power supply conductive columns 33 are electrically connected to the second line paths 2. The core power supply conductive columns 33 are electrically connected to the core power supply contacts 443 through the second line paths 2. In this way, the core power supply signal on the package substrate 10 is transmitted to the second line path 2 on the left side through the core power supply conductive column 33 on the left side. The second line path 2 on the left side transmits the core power supply signal to the core power supply contact 443 of the first chip 41, and then transmits the core power supply signal to the first uncovered area M2 of the first chip 41. The core power supply signal on the package substrate 10 is transmitted to second line path 2 on the right side through the core power supply conductive column 33 on the right side. The second line path 2 on the right side transmits the core power supply signal to the core power supply contact 443 of the second chip 42, and then transmits the core power supply signal to the second uncovered area N2 of the second chip 42.

It should be understood that, from sectional views shown in FIG. 4A and FIG. 4C, there are first line paths 1 and second line paths 2 on the left side and the right side of the first connection chip 21. However, from a top view shown in FIG. 4B, the first line paths 1 and the second line paths 2 may be disposed on the upper side, the lower side, the left side, and the right side of the first connection chip 21. In other words, the conductive columns 30 around the first connection chip 21 may transmit signals to the first chip 41 and the second chip 42 through the first line paths 1 and/or the second line paths 2.

For example, as shown in FIG. 4B, the IP power supply conductive columns 31 located below the first connection chip 21 may transmit the IP power supply signals to the first chip 41 and the second chip 42 through the first line paths 1.

In addition, as shown in FIG. 4A, in this embodiment of this application, a case in which the conductive column 30 on the left side can only transmit the power supply signal to the first chip 41 on the left side through the first line path 1 is not limited. The conductive column 30 on the left side may alternatively transmit the power supply signal to the second chip 42 on the right side through the first line path 1. Similarly, the conductive column 30 on the right side may alternatively transmit the power supply signal to the first chip 41 on the left side through the first line path 1.

In some embodiments, considering that a shorter line indicates a smaller loss and a smaller resistance, a proximity principle may be used when a conductive column 30 connected to a first line path 1 and a conductive column 30 connected to a second line path 2 are selected.

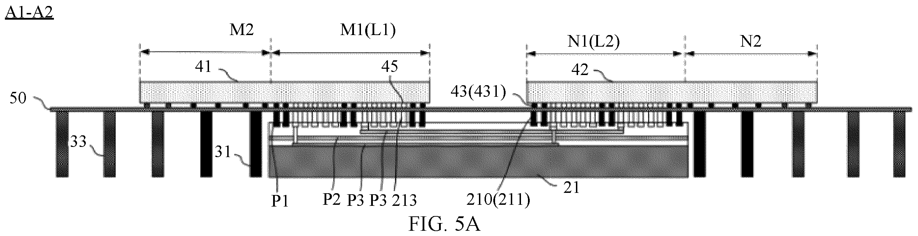

As shown in FIG. 5A (which is a sectional view in a direction A1-A2 in FIG. 4B), a plurality of first auxiliary contacts 210 are further disposed on a side that is of the first connection chip 21 and that faces the redistribution layer 50, and the first auxiliary contacts 210 and the first contacts 43 are disposed correspondingly.

That the first auxiliary contacts 210 and the first contacts 43 are disposed correspondingly may be understood as that projection of the first contacts 43 overlaps the first auxiliary contacts 210. In other words, the first contacts 43 are located above the first auxiliary contacts 210.

To be specific, the first auxiliary contacts 210 are disposed in a first overlapping area L1 that is of the first connection chip 21 and that overlaps the first covered area M1 of the first chip 41. The first auxiliary contacts 210 are also disposed in a second overlapping area L2 that is of the first connection chip 21 and that overlaps a second overlapping area N1 of the second chip 42.

In some embodiments, the first contacts 43 include the first IP power supply contact 431 and the first ground contact 432. Correspondingly, the first auxiliary contacts 210 include a first auxiliary IP power supply contact 211 and a first auxiliary ground contact 212.

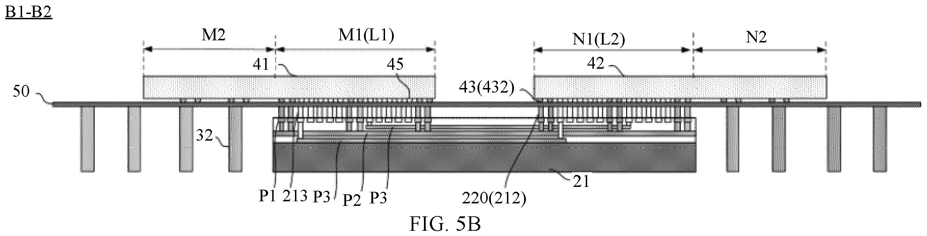

As shown in FIG. 5A, the first auxiliary IP power supply contact 211 and the first IP power supply contact 431 are disposed correspondingly. As shown in FIG. 5B (which is a sectional view in a direction B1-B2 in FIG. 4B), the first auxiliary ground contact 212 and the first ground contact 432 are disposed correspondingly.

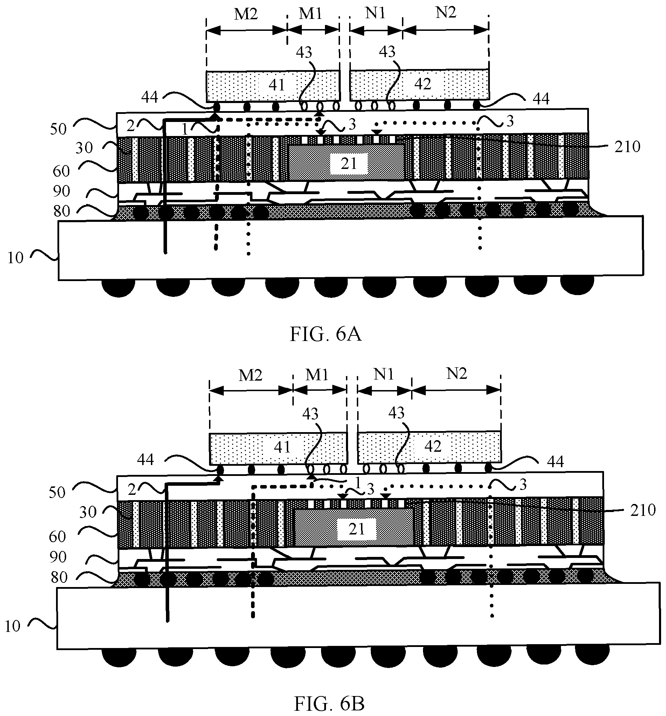

In some embodiments, as shown in FIG. 6A, the redistribution layer 50 further includes a third line path 3, and the third line path 3 is used to electrically connect a part of the plurality of conductive columns 30 to the first auxiliary contact 210.

In this way, the power supply signal on the package substrate 10 is transmitted to the third line path 3 through the conductive column 30, then transmitted to the first auxiliary contact 210 through the third line path 3, and then transmitted into the inside of the first connection chip 21 as required.

A type of the signal transmitted on the third line path 3 is not limited. For example, a part of the third line paths 3 may be used to transmit the IP power supply signal, and a part of the third line paths 3 may be used to transmit the ground signal.

In some embodiments, as shown in FIG. 6A, the first line path 1 and the third line path 3 do not overlap.

In some other embodiments, as shown in FIG. 6B, the first line path 1 and the third line path 3 partially overlap.

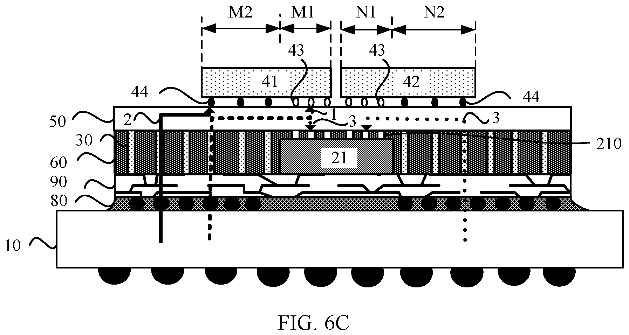

In still some other embodiments, as shown in FIG. 6C, the first line path 1 and the third line path 3 basically completely overlap. At a position close to the first contact 43 and the first auxiliary contact 210, transmission is performed separately, and the signals are respectively transmitted to the first contact 43 on the redistribution layer 50 and the first auxiliary contact 210 below the redistribution layer 50.

In this case, the first line path 1 in FIG. 4B may alternatively be considered as the third line path 3.

Based on this, with reference to FIG. 5A and FIG. 6C, a part of the plurality of IP power supply conductive columns 31 is electrically connected to the third line path 3. The IP power supply signal on the package substrate 10 is transmitted to the third line path 3 through the IP power supply conductive column 31. The third line path 3 is electrically connected to the first auxiliary IP power supply contact 211. The third line path 3 on the left side transmits the IP power supply signal to the first auxiliary IP power supply contact 211 in the first overlapping area L1. The third line path 3 on the right side transmits the IP power supply signal to the first auxiliary IP power supply contact 211 in the second overlapping area L2.

A plurality of first auxiliary IP power supply contacts 211 may be electrically connected, or may not be electrically connected in the first connection chip 21 as required. When the plurality of first auxiliary IP power supply contacts 211 need to be electrically connected in the first connection chip 21, for example, the plurality of first auxiliary IP power supply contacts 211 may be electrically connected through a metal layer P1 in the first connection chip 21. In other words, the metal layer P1 is used as a network plane for implementing interconnection between the first auxiliary IP power supply contacts 211.

The metal layer P1 may be, for example, a pad layer of the first connection chip 21. For example, the first auxiliary contact 210 may be disposed on the metal layer P1, and the metal layer P1 is connected to another metal layer through a via (via) between the metal layers.

With reference to FIG. 5B and FIG. 6C, a part of the plurality of ground conductive columns 32 is electrically connected to the third line path 3. The ground signal on the package substrate 10 is transmitted to the third line path 3 through the ground conductive column 32. The third line path 3 is electrically connected to the first auxiliary ground contact 212. The third line path 3 on the left side transmits the ground signal to the first auxiliary ground contact 212 in the first overlapping area L1. The third line path 3 on the right side transmits the ground signal to the first auxiliary ground contact 212 in the second overlapping area L2.

For example, a plurality of first auxiliary ground contacts 212 may be electrically connected through a metal layer P2 in the first connection chip 21.

It should be understood that, from sectional views shown in FIG. 6A to FIG. 6C, there are third line paths 3 on the left side and the right side of the first connection chip 21. However, actually, the third line paths 3 may be disposed on the upper side, the lower side, the left side, and the right side of the first connection chip 21, provided that the paths are disposed properly as required.

In some embodiments, as shown in FIG. 5A, the first chip 41 and the second chip 42 further include third contacts 45. The third contacts 45 are distributed in the area (the first covered area M1) that is at the bottom of the first chip 41 and that is covered by projection of the first connection chip 21 and the area (the second covered area N1) that is at the bottom of the second chip 42 and that is covered by projection of the first connection chip 21.

As shown in FIG. 5A, the first connection chip 21 further includes a third auxiliary contact 213, and the third auxiliary contact 213 and the third contact 45 are distributed correspondingly. In other words, projection of the third contact 45 and the third auxiliary contact 213 overlap. To be specific, a third auxiliary contact 213 that corresponds to the third contact 45 in the first covered area M1 is distributed in the first overlapping area L1 of the first connection chip 21, and a third auxiliary contact 213 that corresponds to the third contact 45 in the second covered area N1 is distributed in the second overlapping area L2 of the first connection chip 21.

The third auxiliary contact 213 in the first overlapping area L1 and the third auxiliary contact 213 in the second overlapping area L2 are electrically connected in the first connection chip 21. For example, the third auxiliary contact 213 in the first overlapping area L1 and the third auxiliary contact 213 in the second overlapping area L2 are electrically connected through a metal layer P3 in the first connection chip 21. There may be one or more metal layers P3, provided that a quantity of metal layers is set properly as required.

In some embodiments, as shown in FIG. 5A, to enable the metal layer P2 configured to transmit the ground signal to perform a function of noise reduction and isolation, one metal layer P2 may be disposed between adjacent metal layers P3. Certainly, based on a design of the metal layer, each metal layer may further include a part of patterns used to transmit the ground signal. A case in which each metal layer can transmit only one type of signal is not limited.

It may be understood that, although a part of the third auxiliary contacts 213 is not electrically connected in FIG. 5A, it does not indicate that the part of the third auxiliary contacts 213 cannot be electrically connected. The part of the third auxiliary contacts 213 is not electrically connected at a A1-A2 cross section, and the part of the third auxiliary contacts 213 may be electrically connected at another cross section.

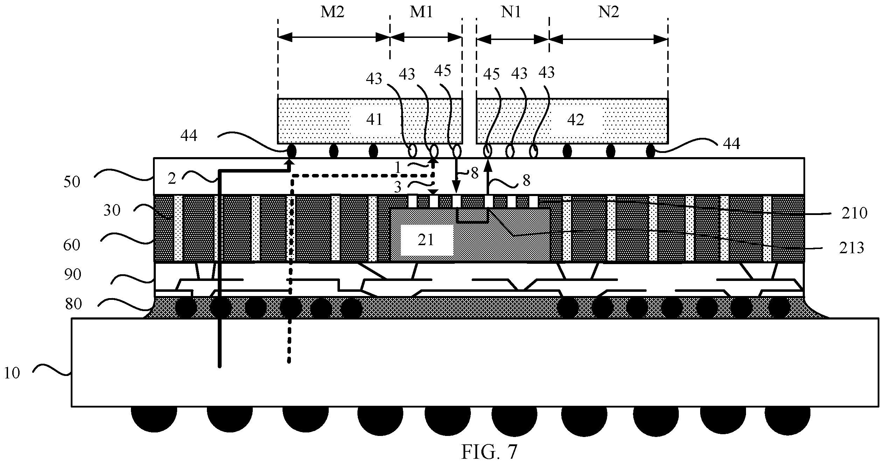

As shown in FIG. 7, the redistribution layer 50 further includes an eighth line path 8, and the eighth line path 8 is used to electrically connect the third contact 45 to the third auxiliary contact 213. In this way, an interconnection signal on the first chip 41 is transmitted to the eighth line path 8 through the third contact 45, then transmitted to the third auxiliary contact 213 in the first overlapping area L1. Subsequently, the interconnection signal is transmitted from the inside of the first connection chip 21 to the third auxiliary contact 213 in the second overlapping area L2, then transmitted to the third contact 45 on the second chip 42 through the eighth line path 8, and then transmitted to the inside of the second chip 42, so that interconnection between the first chip 41 and the second chip 42 is implemented.

The chip package structure shown in FIG. 7 includes the following power supply paths.

First path: A part of the conductive columns 30 transmits the power supply signal on the package substrate 10 to the first covered area M1 of the first chip 41 through the first line path 1. A part of the conductive columns 30 transmits the power supply signal on the package substrate 10 to the first uncovered area M2 of the first chip 41 through the second line path 2. Therefore, power is supplied from the package substrate 10 to the first chip 41 through the conductive columns 30 and the first line path 1 and the second line path 2 that are on the redistribution layer 50.

Second path: Apart of the conductive columns 30 transmits the power supply signal on the package substrate 10 to the second covered area N1 of the second chip 42 through the first line path 1. A part of the conductive columns 30 transmits the power supply signal on the package substrate 10 to the second uncovered area N2 of the second chip 42 through the second line path 2. Therefore, power is supplied from the package substrate 10 to the second chip 42 through the conductive columns 30 and the first line path 1 and the second line path 2 that are on the redistribution layer 50.

Third path: A part of the conductive columns 30 transmits the power supply signal on the package substrate 10 to the first overlapping area L1 of the first connection chip 21 through the third line path 3. A part of the conductive columns 30 transmits the power supply signal on the package substrate 10 to the second overlapping area L2 of the first connection chip 21 through the third line path 3. Therefore, power is supplied from the package substrate 10 to the first connection chip 21 through the conductive columns 30 and the third line path 3 on the redistribution layer 50.

A path that implements interconnection between the first chip 41 and the second chip 42 is as follows: The interconnection signal on the first chip 41 is transmitted to the first overlapping area L1 of the first connection chip 21 through an eighth power line path 8, the interconnection signal is transmitted from the first overlapping area L1 to the second overlapping area L2 in the first connection chip 21, and then the interconnection signal is transmitted from the second overlapping area L2 to the second chip 42 through the eighth power line path 8. Therefore, interconnection between the first chip 41 and the second chip 42 is implemented.

In some embodiments, at least a part of the first auxiliary contacts 210 is electrically connected in the first connection chip 21.

The first auxiliary contact 210 electrically connected in the first connection chip 21 may include the first auxiliary ground contact 212 configured to transmit the ground signal, or may include a first auxiliary IP power supply auxiliary contact 211 configured to transmit the IP power supply signal.

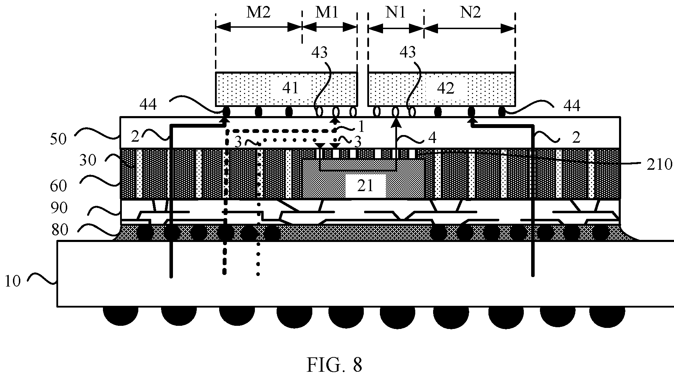

As shown in FIG. 8, the redistribution layer 50 further includes a fourth line path 4, and the fourth line path 4 is used to electrically connect the first contact 43 at the bottom of the second chip 42 to the first auxiliary contact 210 at a corresponding position (the second overlapping area L2) of the first connection chip 21.

In this way, the power supply signal received by the first auxiliary contact 210 is transmitted to the first contact 43 on the second chip 42 through the fourth line path 4, and subsequently transmitted to the inside of the second chip 42.

In some embodiments, the first auxiliary contact 210 that is electrically connected through the fourth line path 4 is the first power supply auxiliary contact 211, and the first contact 43 is the first IP power supply contact 431.

Based on this, as shown in FIG. 8, on the basis of the power supply paths shown in FIG. 7, the chip package structure further includes the following power supply path.

Fourth power supply path: A part of the conductive columns 30 transmits the power supply signal on the package substrate 10 to the first overlapping area L1 of the first connection chip 21 through the third line path 3. The power supply signal is transmitted from the inside of the first connection chip 21 to the second overlapping area L2 through the first overlapping area L1. The power supply signal is transmitted to the second covered area N1 of the second chip 42 through the fourth line path 4 in the second overlapping area L2, and subsequently transmitted to the second chip 42. Therefore, power is supplied from the package substrate 10 to the first connection chip 21 through the conductive column 30 on a side of the first chip 41 and the third line paths 3 on the redistribution layer 50, and then from the first connection chip 21 to the second chip 42 through the fourth line path 4 on the redistribution layer 50.

It should be understood that, a difference between the fourth line path 4 and the eighth line path 8 on the redistribution layer 50 lies in that the fourth line path 4 is used to transmit the power supply signal to the second chip 42, and the eighth line path 8 is used to transmit the interconnection signal between the first chip 41 and the second chip 42.

In this embodiment of this application, the fourth line path 4 is disposed in the redistribution layer 50, so that a power supply signal on a conductive column 30 that is close to the first chip 41 can be transmitted to the second chip 42 through the first connection chip 21. In this way, when a power supply requirement of the second chip 42 is large, and space for disposing a conductive column 30 on a side on which the second chip 42 is located is insufficient, a conductive column 30 on a side on which the first chip 41 is located is used to supply power to the second chip 42, so that the power supply requirement of the second chip 42 can be met.

It should be noted that FIG. 4B is a top view of the chip package structure. The top view shows an arrangement manner of the plurality of conductive columns 30 (including the IP power supply conductive column 31, the ground conductive column 32, and the core power supply conductive column 33) and an arrangement manner of the first contacts 43 (the first IP power supply contact 431 and the first ground contact 432), the second contacts 44 (the second IP power supply contact 441, the second ground contact 442, and the core power supply contact 443). However, the figure is only used as an example, and no limitation is imposed. An arrangement order of each row may also be adjusted.

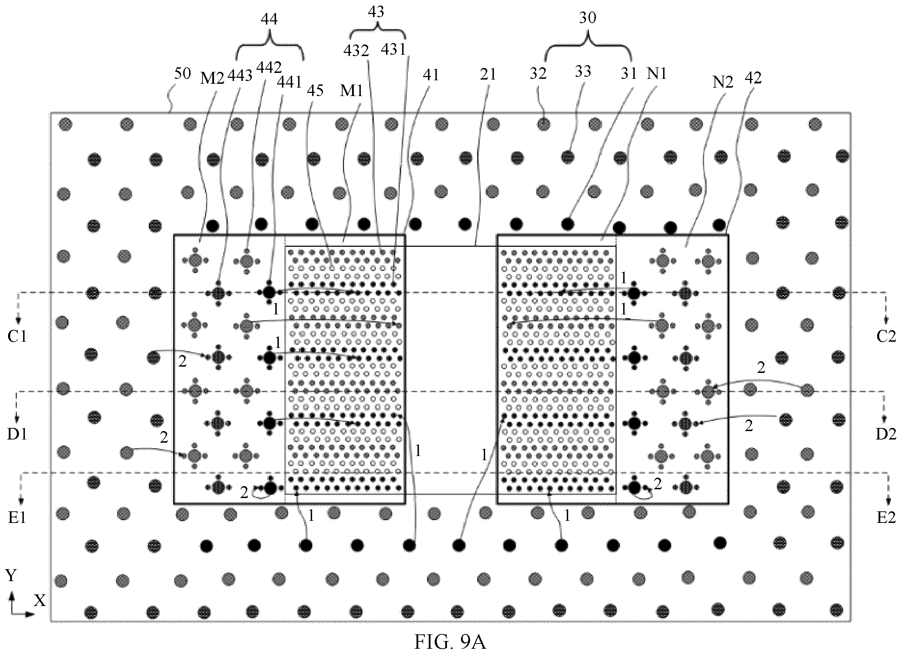

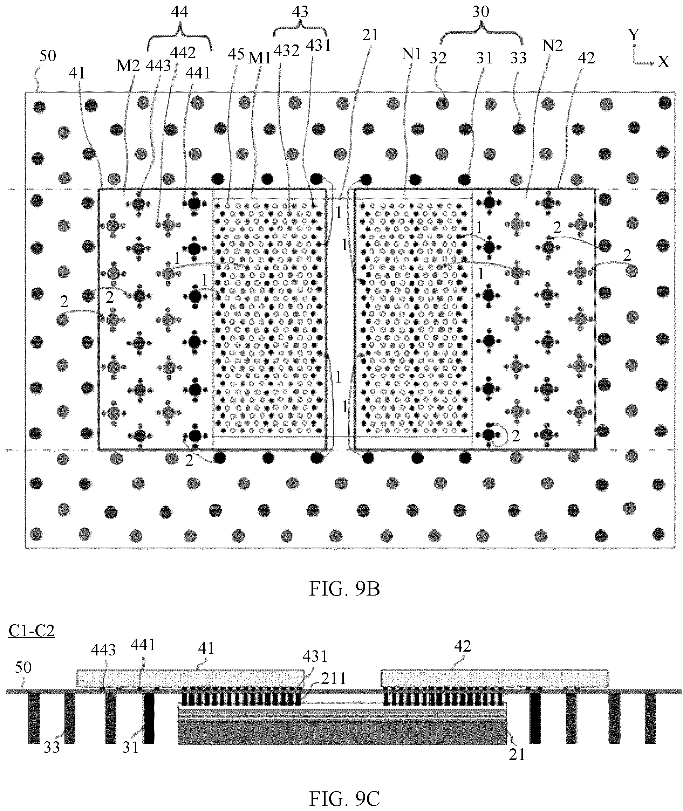

An arrangement manner of the conductive columns 30 and an arrangement manner of the first contacts 43 and the second contacts 44 may alternatively be shown in FIG. 9A and FIG. 9B. This is not limited in this embodiment of this application.

For an arrangement of the conductive columns 30, in some embodiments, the plurality of conductive columns 30 are arranged in a plurality of rows in a first direction X and a plurality of columns in a second direction Y In this embodiment of this application, from a perspective of FIG. 9A, conductive columns 30 located above and below edges (dotted lines in the figure) of the first chip 41 and the second chip 42 are arranged in the plurality of rows. Conductive columns 30 located on the left sides and the right sides of the edges of the first chip 41 and the second chip 42 are arranged in the plurality of columns. Conductive columns 30 in adjacent rows are arranged in a staggered manner, and conductive columns 30 in adjacent columns are arranged in the staggered manner.

In some embodiments, the IP power supply conductive column 31 is disposed close to the first connection chip 21 relative to the core power supply conductive column 33.

In some embodiments, a row of power supply conductive columns is disposed between adjacent rows of ground conductive columns 32. The row of power supply conductive columns may include the IP power supply conductive columns 31. The row of power supply conductive columns may alternatively include the core power supply conductive columns 33. The row of power supply conductive columns may alternatively include both the IP power supply conductive column 31 and the core power supply conductive column 33.

In some embodiments, a row of conductive columns 30 closest to the first connection chip 21 is a row of IP power supply conductive columns 31 or a row of ground conductive columns 32. A column of conductive columns 30 closest to the first connection chip 21 is a column of IP power supply conductive columns 31 or a column of ground conductive columns 32.

For an arrangement of the second contacts 44, in some embodiments, the second contacts 44 and the conductive columns 30 that are located below the first chip 41 and the second chip 42 are disposed correspondingly. The second contacts 44 are located around peripheries of the conductive columns 30 that are correspondingly disposed for the second contacts 44.

In other words, as shown in FIG. 9C (which is a sectional view in a direction C1-C2 in FIG. 9A), a second contact 44 that is correspondingly disposed for the IP power supply conductive column 31 is the second IP power supply contact 441. At least one second IP power supply contact 441 may be correspondingly disposed for one IP power supply conductive column 31. When a plurality of second IP power supply contacts 441 may be correspondingly disposed for one IP power supply conductive column 31, as shown in FIG. 9A, projection of the plurality of second IP power supply contacts 441 is located around a periphery of the IP power supply conductive column 31 that is correspondingly disposed for the plurality of second IP power supply contacts 441, so that a conductive path is enhanced.

Similarly, as shown in FIG. 9C, a second contact 44 that is correspondingly disposed for the core power supply conductive column 33 is the core power supply contact 443. At least one core power supply contact 443 may be correspondingly disposed for one core power supply conductive column 33. When a plurality of core power supply contacts 443 may be correspondingly disposed for one core power supply conductive column 33, as shown in FIG. 9A, projection of the plurality of core power supply contacts 443 are located around a periphery of the core power supply conductive column 33 that is correspondingly disposed for the plurality of core power supply contacts 443.

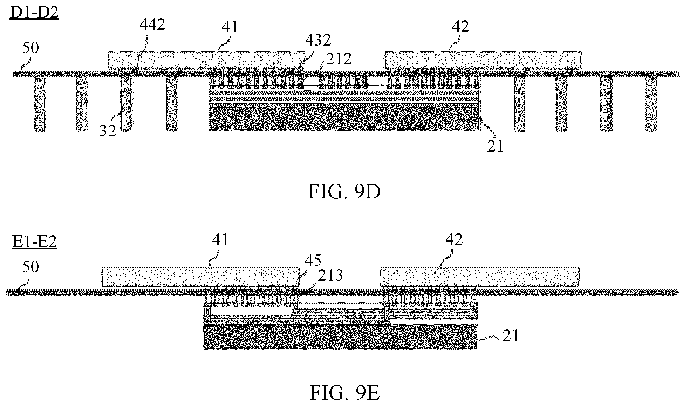

Similarly, as shown in FIG. 9D, a second contact 44 that is correspondingly disposed for the ground conductive column 32 is the second ground contact 442. At least one second ground contact 442 may be correspondingly disposed for one ground conductive column 32. When a plurality of second ground contacts 442 may be correspondingly disposed for one ground conductive column 32, as shown in FIG. 9A, projection of the plurality of second ground contacts 442 are located around a periphery of the ground conductive column 33 that is correspondingly disposed for the plurality of second ground contacts 442.

For an arrangement of contacts in the first covered area M1 and the second covered area N1, in some embodiments, as shown in FIG. 9A, the plurality of first contacts 43 are arranged in a plurality of rows in the second direction Y, and a plurality of first contacts 43 in each row are sequentially arranged in the first direction X. A plurality of third contacts 45 are arranged in a plurality of rows in the second direction Y, and a plurality of third contacts 45 in each row are sequentially arranged in the first direction X.

At least one row of first IP power supply contacts 431, at least one row of third contacts 45, at least one row of first ground contacts 432, and at least one row of third contacts 45 are used as one group, and are cyclically arranged in the second direction Y

Optionally, as shown in FIG. 9A, contacts in adjacent rows are arranged in the staggered manner.

Optionally, as shown in FIG. 9A, conductive columns 30 adjacent to each row of first IP power supply contacts 431 are the IP power supply conductive columns 31, and conductive columns 30 adjacent to each row of first ground contacts 432 are the ground conductive columns 32.

In some other embodiments, as shown in FIG. 9B, the plurality of first contacts 43 are arranged in a plurality of columns in the first direction X, and a plurality of first contacts 43 in each column are sequentially arranged in the second direction Y A plurality of third contacts 45 are arranged in a plurality of columns in the first direction X, and a plurality of third contacts 45 in each column are sequentially arranged in the second direction Y.

At least one column of first IP power supply contacts 431, at least one column of third contacts 45, at least one column of first ground contacts 432, and at least one column of third contacts 45 are used as a one group, and are cyclically arranged in the first direction X.

Optionally, as shown in FIG. 9B, contacts in adjacent columns are arranged in the staggered manner.

Optionally, as shown in FIG. 9B, a column of first contacts 43 closest to the conductive columns 30 are the first IP power supply contacts 431.

In some other embodiments, as shown in FIG. 4B, the plurality of first contacts 43 are arranged in a plurality of columns in the first direction X, and a plurality of first contacts 43 in each column are sequentially arranged in the second direction Y A plurality of third contacts 45 are arranged in a plurality of columns in the first direction X, and a plurality of third contacts 45 in each column are sequentially arranged in the second direction Y

At least one column of first contacts 43 and at least one column of third contacts 45 are disposed according to a rule of an alternate arrangement in the first direction X. Each column of first contacts 43 is formed in which first IP power supply contacts 431 and first ground contacts 432 are alternately arranged.

Optionally, in a column of first contacts 43 closest to the conductive columns 30, a conductive column 30 adjacent to the first IP power supply contact 431 is the IP power supply conductive column 31, and a conductive column 30 adjacent to the first ground contact 432 is the ground conductive column 32.

For distribution of contacts on the first connection chip 21, in some embodiments, as shown in FIG. 9C, the first auxiliary IP power supply contacts 211 in the first auxiliary contacts 210 and the first IP power supply contacts 431 in the first chip 41 and the second chip 42 are disposed correspondingly.

In some embodiments, as shown in FIG. 9D, the first auxiliary ground contacts 212 in the first auxiliary contacts 210 and the first ground contacts 432 in the first chip 41 and the second chip 42 are disposed correspondingly.

In some embodiments, as shown in FIG. 9E, the third auxiliary contacts 213 and the third contacts 45 in the first chip 41 and the second chip 42 are disposed correspondingly.

In other words, an arrangement rule of contacts in the first overlapping area L1 of the first connection chip 21 is the same as an arrangement rule of contacts in the first covered area M1 of the first chip 41. An arrangement rule of contacts in the second overlapping area L2 of the first connection chip 21 is the same as an arrangement rule of contacts in the second overlapping area N1 of the second chip 42.

According to the chip package structure provided in this embodiment of this application, the package substrate 10 is welded to the conductive columns 30 through the C4 bumps or the solder balls, and the signals on the package substrate 10 are transmitted to the conductive columns 30. The conductive columns 30 are arranged around the periphery of the first connection chip 21, and are electrically connected to the redistribution layer 50. The signals on the conductive columns 30 are transmitted to the first connection chip 21, the first chip 41, and the second chip 42 through the line paths on the redistribution layer 50, to supply power to the first connection chip 21, the first chip 41, and the second chip 42. Compared with a power supply manner in which the TSV is formed in the first connection chip 21, a power supply manner used in this embodiment of this application can reduce costs on a basis of ensuring a power supply requirement of an internal circuit of the chip package structure. Compared with a manner in which the first chip 41 and the second chip 42 are interconnected and powered through the redistribution layer instead of a connection chip, the power supply manner used in this embodiment of this application can reduce the quantity of metal layers in the redistribution layer 50, and reduce a thickness of the redistribution layer 50.

In addition, because the TSV does not need to be formed in the first connection chip 21 to transmit a power supply signal on the package substrate, an area of the first connection chip 21 may be reduced. This helps implement short-distance and high-density interconnection between the first chip and the second chip. Therefore, a requirement of a chip that features a high bandwidth, a high rate, high performance, and low costs is met.

### Example 2

A difference between Example 2 and Example 1 lies in that second auxiliary contacts are further disposed between a first overlapping area L1 and a second overlapping area L2 of the first connection chip 21.

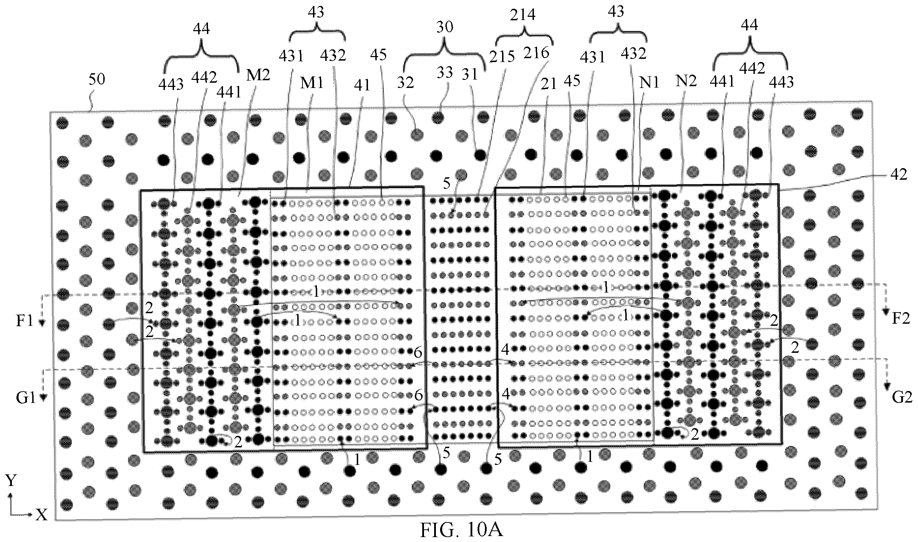

As shown in FIG. 10A, a plurality of second auxiliary contacts 214 are further disposed on a side that is of the first connection chip 21 and that faces the redistribution layer 50, and the second auxiliary contacts 214 are distributed in an area that is of the first connection chip 21 and that is not covered by projection of the first chip 41 or the second chip 42.

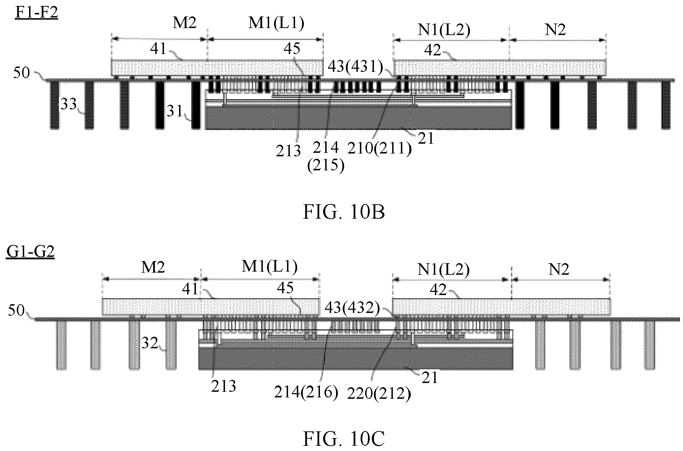

As shown in FIG. 10B (which is a sectional view in a direction F1-F2 in FIG. 10A) and FIG. 10C (which is a sectional view in a direction G1-G2 in FIG. 10A), in some embodiments, the second auxiliary contacts 214 are distributed between the first overlapping area L1 and the second overlapping area L2. That is, the second auxiliary contacts 214 are distributed below a spacing between the first chip 41 and the second chip 42.

As required, the second auxiliary contacts 214 may all be second auxiliary IP power supply contacts 215. Alternatively, the second auxiliary contacts 214 are all second auxiliary ground contacts 216. Alternatively, as shown in FIG. 10A, a part of the second auxiliary contacts 214 is a second auxiliary IP power supply contact 215, and the other part is a second auxiliary ground contact 216.

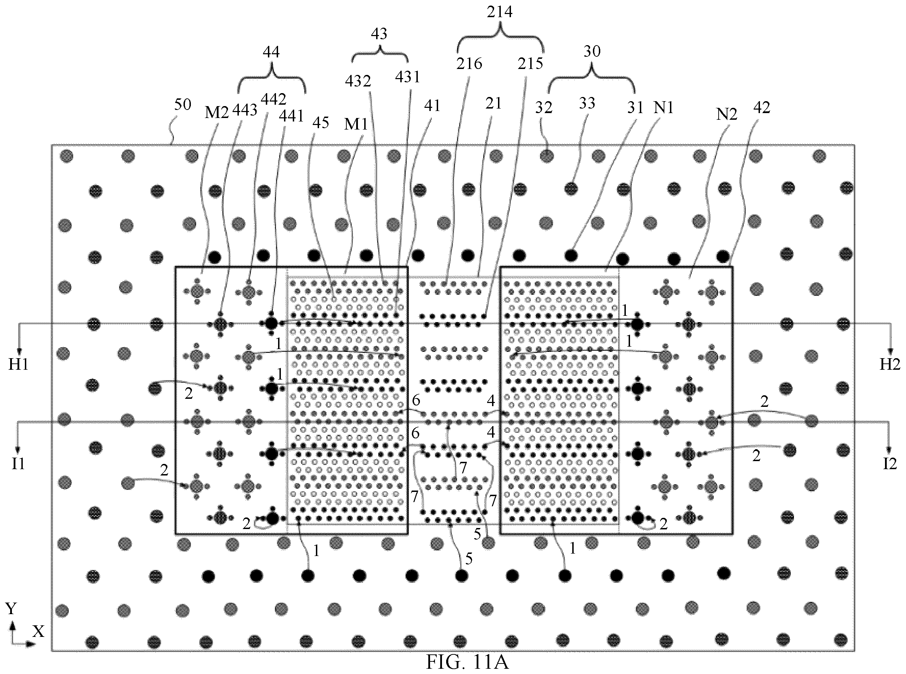

As shown in FIG. 10A and FIG. 11A, based on different arrangement manners of first contacts 43 and third contacts 45 in the first chip 41 and the second chip 42, an arrangement manner of the second auxiliary contacts 214 may also be correspondingly adjusted.

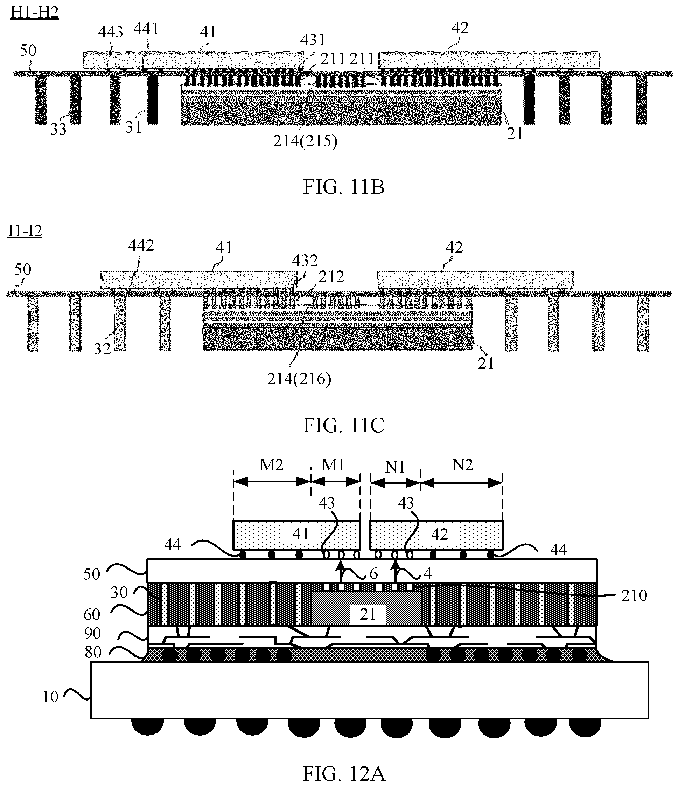

In some embodiments, as shown in FIG. 10B and FIG. 11B (which is a sectional view in a direction H1-H2 in FIG. 11A), a first auxiliary IP power supply contact 211 and the second auxiliary IP power supply contact 215 are disposed in a same row.

In some embodiments, as shown in FIG. 10C and FIG. 11C (which is a sectional view in a direction I1-I2 in FIG. 11A), a first auxiliary ground contact 212 and the second auxiliary ground contact 216 are disposed in a same row.

The second auxiliary contacts 214 are disposed between the first overlapping area L1 and the second overlapping area L2 of the first connection chip 21, and the second auxiliary contacts 214 are connected to the redistribution layer 50. This is equivalent to adding support by using the second auxiliary contacts 214, to increase support strength at the spacing between the first chip 41 and the second chip 42, and avoid breaking of the chip package structure at the spacing between the first chip 41 and the second chip 42.

In some embodiments, at least a part of the second auxiliary contacts 214 is electrically connected to a part of first auxiliary contacts 210.

For example, the first auxiliary contact 210 may be electrically connected to the second auxiliary contact 214 through a metal layer in the first connection chip 21.

Alternatively, for example, the first auxiliary contact 210 may be electrically connected to the second auxiliary contact 214 through a line path on the redistribution layer 50.

It should be understood that the second auxiliary contact 214 is electrically connected to the first auxiliary contact 210. To be specific, the first auxiliary IP power supply contact 211 in the first auxiliary contacts 210 is electrically connected to the second auxiliary IP power supply contact 215 in the second auxiliary contacts 214, and is configured to transmit the first power supply signal. The first auxiliary ground contact 212 in the first auxiliary contacts 210 is electrically connected to the second auxiliary ground contact 216 in the second auxiliary contacts 214, and is configured to transmit the ground signal.

As shown in FIG. 10A and FIG. 11A, the redistribution layer 50 further includes a fifth line path 5. The fifth line path 5 is used to electrically connect a part of the plurality of conductive columns 30 to the second auxiliary contact 214.

For example, an IP power supply conductive column 31 is electrically connected to the second auxiliary IP power supply contact 215 through the fifth line path 5. A ground conductive column 32 is electrically connected to the second auxiliary ground contact 216 through the fifth line path 5.

In this way, two power supply paths may be added to the chip package structure.

Fifth path: A part of the conductive columns 30 transmits the power supply signal on the package substrate 10 to the second auxiliary contact 214 through the fifth line path 5, and the power supply signal is transmitted from the inside of the first connection chip 21 to the first overlapping area L1 and the second overlapping area L2 of the first connection chip 21. Therefore, power is supplied from the package substrate 10 to the first connection chip 21 through the conductive column 30 and the fifth line path 5 on the redistribution layer 50.

Sixth path: A part of the conductive columns 30 transmits the power supply signal on the package substrate 10 to the second auxiliary contact 214 through the fifth line path 5. After the power supply signals are transmitted to the first connection chip 21, a part of the power supply signals may be further transmitted to the second chip 42 through a fourth line path 4 in the second overlapping area L2. Therefore, power is supplied from the package substrate 10 to the first connection chip 21 through the conductive column 30 and the fifth line path 5 on the redistribution layer 50, and then to the second chip 42 through the fourth line path 4 on the redistribution layer 50.

In some embodiments, as shown in FIG. 10A, FIG. 11A, and FIG. 12A, the redistribution layer 50 further includes a sixth line path 6. The sixth line path 6 is used to electrically connect the first contact 43 at a bottom of the first chip 41 to the first auxiliary contact 210 at a corresponding position (the first overlapping area L1) of the first connection chip 21.

In this way, a power supply path may be added to the chip package structure.

Seventh path: A part of the conductive columns 30 transmits the power supply signal on the package substrate 10 to the second auxiliary contact 214 through the fifth line path 5. After the power supply signals are transmitted to the first connection chip 21, a part of the power supply signals may be further transmitted to the first chip 41 through the sixth line path 6 in the first overlapping area L1. Therefore, power is supplied from the package substrate 10 to the first connection chip 21 through the conductive column 30 and the fifth line path 5 on the redistribution layer 50, and then to the first chip 41 through the sixth line path 6 on the redistribution layer 50.

It should be understood that, a difference between the sixth line path 6 and an eighth line path 8 on the redistribution layer 50 lies in that the sixth line path 6 is used to transmit the power supply signal to the first chip 41, and the eighth line path 8 is used to transmit an interconnection signal between the first chip 41 and the second chip 42.

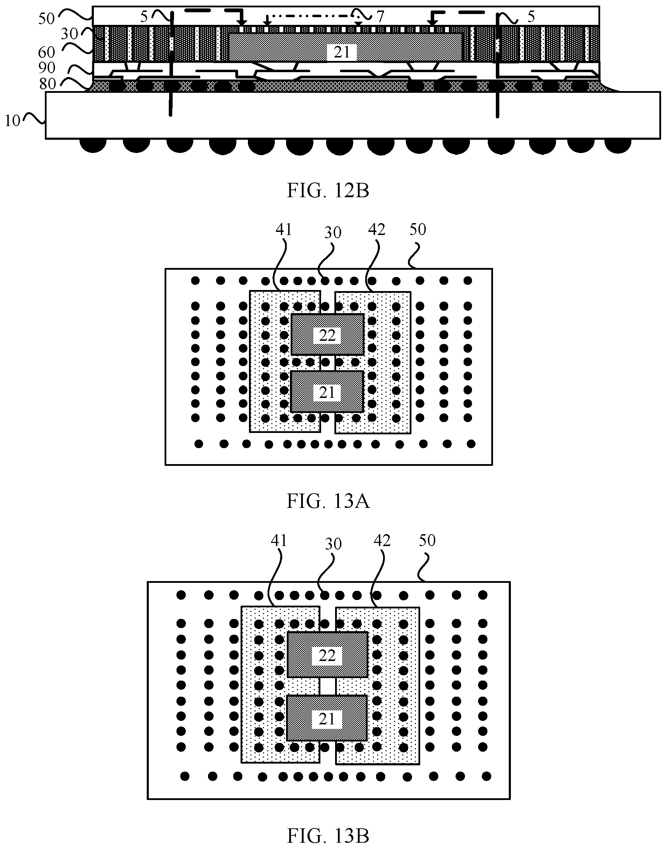

As required, in some embodiments, as shown in FIG. 11A and FIG. 12B, the redistribution layer 50 further includes a seventh line path 7. The seventh line path 7 is used to electrically connect at least a part of the second auxiliary contacts 214.

In some other embodiments, at least a part of the second auxiliary contacts 214 is electrically connected in the first connection chip 21.

The second auxiliary contacts 214 are disposed between the first overlapping area L1 and the second overlapping area L2. In one aspect, the second auxiliary contacts 214 can support the redistribution layer 50 and balance forces imposed on the redistribution layer 50. In another aspect, a line path may be added to the redistribution layer 50, so that the signal on the package substrate 10 is transmitted from the peripheral conductive column 30 to an area between the first overlapping area L1 and the second overlapping area L2, and then to the inside of the first connection chip 21, the first chip 41, or the second chip 42. This enriches a power supply network and a ground network of the first connection chip 21, and enhances power supply and current return in the chip package structure.

### Example 3

A difference between Example 3 and Example 1 and Example 2 lies in that the chip package structure further includes a second connection chip.

As shown in FIG. 13A, the chip package structure further includes a second connection chip 22. The second connection chip 22 and the first connection chip 21 are disposed side by side on the second surface of the redistribution layer 50.

Projection of the second connection chip 22 covers a part of the areas of the first chip 41 and the second chip 42. To be specific, a part of the area of the first chip 41 is located right above the second connection chip 22, and a part of the area of the second chip 42 is located right above the second connection chip 22. Alternatively, it is understood as that a part of the area of the first chip 41 is lapped over the second connection chip 22, and a part of the area of the second chip 42 is lapped over the second connection chip 22. The first chip 41 and the second chip 42 are interconnected through the second connection chip 22.

In other words, as shown in FIG. 13A, a part of a functional area of the first chip 41 and a part of a functional area of the second chip 42 are interconnected through the first connection chip 21, and a part of the functional area of the first chip 41 and a part of the functional area of the second chip 42 are interconnected through the second connection chip 22.

Certainly, the first chip 41 and the second chip 42 may be interconnected through a plurality of connection chips. A quantity of connection chips is not limited in the chip package structure provided in this embodiment of this application, provided that the quantity is set properly as required.

In addition, as shown in FIG. 13A, a conductive column 30 may be disposed between the first connection chip 21 and the second connection chip 22. As shown in FIG. 13B, a conductive column 30 may alternatively not be disposed between the first connection chip 21 and the second connection chip 22.

A structure of the second connection chip 22 may be the same as that of the first connection chip 21, provided that the second connection chip 22 is correspondingly disposed for the first chip 41 and the second chip 42.

When an interconnection area between the first chip 41 and the second chip 42 is large, or a plurality of groups of functional areas that need to be interconnected are far away from each other, a plurality of interconnection chips are disposed, so that a line path can be shortened, performance after interconnection is improved, and different structure requirements are met.

### Example 4

A difference between Example 4 and Example 1 to Example 3 lies in that the chip package structure further includes a third chip.

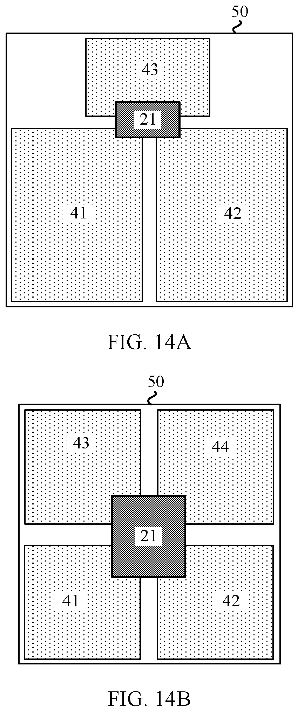

As shown in FIG. 14A, the chip package structure further includes a third chip 43.

The third chip 43 is disposed on the first surface of the redistribution layer 50, and is spaced from the first chip 41 and the second chip 42. A part of an area of the third chip 43 is covered by projection of the first connection chip 21.

For a structure and a design of the third chip 43, refer to structures of the first chip 41 and the second chip 42. The third chip 43 may be interconnected with the first chip 41 through the first connection chip 21. The third chip 43 may alternatively be interconnected with the second chip 42 through the first connection chip 21. The third chip 43 may alternatively be interconnected with both the first chip 41 and the second chip 42 through the first connection chip 21.

For a power supply path of the third chip 43, refer to the foregoing descriptions of the power supply paths of the first chip 41 and the second chip 42.

Certainly, a quantity of chips interconnected through the first connection chip 21 is not limited in this embodiment of this application. There may be two chips, three chips shown in FIG. 14A, four chips shown in FIG. 14B (including a fourth chip 44), or more chips, provided that the quantity is set properly as required.

The chip package structure provided in embodiments of this application has a flexible design and strong applicability.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising: a first chip, a second chip, a first connection chip, a redistribution layer, a plurality of conductive columns, and a package substrate, wherein
the redistribution layer comprises a first surface and a second surface that are opposite to each other;
the first chip and the second chip are disposed side by side on the first surface of the redistribution layer, and the first chip and the second chip are spaced from each other;
the first connection chip is disposed on the second surface of the redistribution layer;
a plurality of first contacts and a plurality of second contacts are disposed at a bottom of the first chip and a bottom of the second chip, wherein the first contacts are distributed in areas that are at the bottom of the first chip and the bottom of the second chip and that are covered by projection of the first connection chip, and the second contacts are distributed in areas that are at the bottom of the first chip and the bottom of the second chip and that are not covered by the projection of the first connection chip;
the redistribution layer is supported above the package substrate by the plurality of conductive columns, and the plurality of conductive columns are disposed around a periphery of the first connection chip; and
a first line path and a second line path are disposed in the redistribution layer, wherein the first line path is used to electrically connect a part of the plurality of conductive columns to the first contact, and the second line path is used to electrically connect a part of the plurality of conductive columns to the second contact.

2. The chip package structure according to claim 1, wherein a plurality of first auxiliary contacts are further disposed on a side that is of the first connection chip and that faces the redistribution layer, and the first auxiliary contacts and the first contacts are disposed correspondingly; and
the redistribution layer further comprises a third line path, and the third line path is used to electrically connect a part of the plurality of conductive columns to the first auxiliary contact.

3. The chip package structure according to claim 2, wherein at least a part of the first auxiliary contacts is electrically connected in the first connection chip; and
the redistribution layer further comprises a fourth line path, and the fourth line path is used to electrically connect the first contact at the bottom of the second chip to the first auxiliary contact at a corresponding position of the first connection chip.

4. The chip package structure according to any one of claims 1 to 3, wherein a plurality of second auxiliary contacts are further disposed on the side that is of the first connection chip and that faces the redistribution layer, and the second auxiliary contacts are distributed in an area that is of the first connection chip and that is not covered by projection of the first chip or the second chip.

5. The chip package structure according to claim 4, wherein at least a part of the second auxiliary contacts is electrically connected to a part of the first auxiliary contacts in the first connection chip; and
the redistribution layer further comprises a fifth line path, and the fifth line path is used to electrically connect a part of the plurality of conductive columns to the second auxiliary contact.

6. The chip package structure according to claim 5, wherein the redistribution layer further comprises a sixth line path, and the sixth line path is used to electrically connect the first contact at the bottom of the first chip to the first auxiliary contact at a corresponding position of the first connection chip.

7. The chip package structure according to claim 5, wherein the redistribution layer further comprises a seventh line path, and the seventh line path is used to electrically connect at least a part of the second auxiliary contacts.

8. The chip package structure according to any one of claims 1 to 7, wherein the first chip and the second chip further comprise a plurality of third contacts, and the third contacts are distributed in the areas that are at the bottom of the first chip and the bottom of the second chip and that are covered by the projection of the first connection chip;
the first connection chip further comprises a plurality of third auxiliary contacts, and the third auxiliary contacts and the third contacts are distributed correspondingly; and
the redistribution layer further comprises an eighth line path, and the eighth line path is used to electrically connect the third contact to the third auxiliary contact.

9. The chip package structure according to any one of claims 1 to 8, wherein the first line path is used to transmit an intellectual property power supply signal and a ground signal; and
the second line path is used to transmit the intellectual property power supply signal, a core power supply signal, and the ground signal.

10. The chip package structure according to any one of claims 1 to 9, wherein the chip package structure further comprises a second connection chip, wherein
the second connection chip and the first connection chip are disposed side by side on the second surface of the redistribution layer, and projection of the second connection chip covers a part of areas of the first chip and the second chip.

11. The chip package structure according to any one of claims 1 to 10, wherein the chip package structure further comprises a third chip, wherein
the third chip is disposed on the first surface of the redistribution layer, and is spaced from the first chip and the second chip; and a part of an area of the third chip is covered by the projection of the first connection chip.

12. An electronic device, comprising the chip package structure according to any one of claims 1 to 11 and a printed circuit board, wherein the chip package structure is disposed on the printed circuit board.
